**Europäisches Patentamt**

**European Patent Office**

**Office européen des brevets**

(19)

(11)  **EP 1 202 410 A2**

(12)  **EUROPEAN PATENT APPLICATION**

(43) Date of publication:
**02.05.2002  Bulletin 2002/18**

(51) Int Cl.$^7$: **H01S 5/343**

(21) Application number: **01103571.4**

(22) Date of filing: **20.02.2001**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **26.10.2000  JP 2000327141**

(71) Applicant: **Hitachi, Ltd.
Chiyoda-ku, Tokyo 101-8010 (JP)**

(72) Inventors:
• **Takemoto, Daisaku, Hitachi, Ltd., Int. Prop. Gp.
Chiyoda-ku, Tokyo 100-8220 (JP)**

• **Nomoto, Etsuko, Hitachi, Ltd., Int. Prop. Gp.
Chiyoda-ku, Tokyo 100-8220 (JP)**
• **Tsuchiya, Tomonobu, Hitachi, Ltd., Int. Prop. Gp.
Chiyoda-ku, Tokyo 100-8220 (JP)**
• **Nakahara, Kouji, Hitachi, Ltd., Int. Prop. Gp.
Chiyoda-ku, Tokyo 100-8220 (JP)**

(74) Representative: **Beetz & Partner Patentanwälte
Steinsdorfstrasse 10
80538 München (DE)**

(54)  **Semiconductor laser device**

(57)     A semiconductor laser having high speed modulation function over a wide temperature range can be attained by making an active layer region (305) of a semiconductor laser as a multiple quantum well structure of InGaAlAs or InGaAs material system, and defining the bandgap wavelength of the barrier layer to less than 950nm, or alternatively, by making the bandgap wavelength of a barrier to less than 1000nm and the bandgap wavelength optical guide layer (304,306) substantially equal with or shorter than that of the barrier layer in a structure having a multiple quantum well of the same material system having an active layer (305) and an optical guide layer (304,306) in adjacent therewith.

## FIG. 3(a)

## FIG. 3(b)

**Description**

BACKGROUND OF THE INVENTION

This invention relates to a semiconductor laser device having a multiple quantum well structure and an oscillation wavelength mainly in 1.3 µm to 1.55 µm.

Along with rapid popularization of optical communication networks, extremely high performance has been required for semiconductor lasers for optical communication. Particularly, optical modules used for metro application or 10 Gigabit Ethernet requiring large transmission capacity and intermediate reach have to be reduced for the cost, and semiconductor lasers used therein are required for favorable characteristics over a wide temperature range and very high speed modulation performance of 10 Gbit/s or more by direct modulation.

As a light source for optical communication requiring high speed modulation or long distance transmission, long wavelength semiconductor lasers oscillating at a wavelength from 1.25 µm to 1.6 µm are suitable. As the long wavelength semiconductor lasers, semiconductor lasers using InGaAsP on InP substrate (hereinafter simply referred to as InGaAsP laser) are predominant at present.

For the InGaAsP lasers, the following high speed modulation techniques are proposed. In the typical methods, high speed modulation of laser is intended by increasing the relaxation oscillation frequency.

They include methods of, (1) adopting a multiple quantum well (hereinafter simply referred to as MQW) active layer which has a large number of wells, (2) introducing strain to the well in the MQW and (3) applying p-type modulation doping to the barriers in the MQW. However, since various factors not recognized as physical theory are concerned actually in a complicated manner, no ideal method has yet been established and it is difficult to prepare an InGaAsP laser having a relaxation oscillation frequency of higher than 10 GHz at a high temperature of 85°C.

On the other hand, as one of long wavelength band semiconductor lasers for optical communication having excellent temperature characteristics at high temperature, semiconductor lasers using InGaAlAs materials on InP substrates (hereinafter referred to simply as InGaAlAs laser) are present. In case of InGaAsP layers, the energy barrier to electrons is lower and, on the other hand, the energy barrier to holes is higher. Accordingly, since electrons of small effective mass tend to leak from the well layer, they suffer from remarkable degradation in various laser characteristics such as threshold current or efficiency.

On the other hand, in a case of InGaAlAs multiple quantum well lasers, since the energy barrier to electrons is higher, leakage of electrons from the well is suppressed even at high temperature to obtain a laser of excellent high temperature characteristics. While the energy barrier to the holes is low, since the holes have a sufficiently large effective mass, they do not lead to leakage at high temperature.

The relaxation oscillation frequency of the InGaAlAs laser have been reported, for example, as below.

(1) 10th International Conference on Indium Phosphide and Related Materials (1998): Conference Proceedings, p 729 - p 732.
(2) Extended Abstracts of The Japan Society of Applied Physics (The 61st Autumn Meeting, 2000), p 997, 6p-R-15
(3) Patent Laid-Open Hei 8-172241.

Studied have been made so far only around 1.0 µm to 1.05 µm for bandgap wavelength of the barriers like that in the InGaAsP laser technique. It is consumed that the bandgap wavelength described above has been used in the InGaAsP lasers, because when shorter bandgap wave length than the above is used, the energy barrier of the valance band is excessively large to result in not uniform injection of holes to each of well layers and lowering of efficiency caused thereby to rather lower the modulation speed.

As described above, the barrier layer within a range of the bandgap wavelength like that in InGaAsP lasers has been used so far also in InGaAlAs lasers. There has been found no study for the improvement of the relaxation oscillation frequency in the InGaAlAs lasers with a view point of the dependence on the barrier layer composition, particularly, with a view point of making the wavelength shorter.

SUMMARY OF THE INVENTION

This invention intends to provide a compound semiconductor laser device capable of ensuring high speed operation also in a high temperature atmosphere.

This invention provides a semiconductor laser structure further utilizing the high speed modulation characteristics of an InGaAlAs laser device based on the reason that the InGaAlAs laser device is excellent in modulation characteristics and provides sufficient performance as optical source for communication at high temperature and high speed.

This invention provides, as a typical first feature, a semiconductor laser device comprising a multiple quantum well active layer having InGaAs or InGaAlAs as a well layer and InGaAlAs or InAlAs as a barrier formed on an InP substrate in which the bandgap wavelength at 25°C of the barrier layer is 700 nm or more and less than 950 nm. The bandgap wavelength always means hereinafter a value at 25°C.

This invention also provides, as a typical second feature, a semiconductor laser device comprising a multiple quantum well active layer having InGaAs or InGaAlAs as a well layer and InGaAlAs or InAlAs as a barrier formed on an InP substrate, having a first optical guide layer and a second optical guide layer of a single index or a graded index in contact with the multiple quantum well active layer on the side of the InP substrate and on the side opposite thereto, in which the bandgap wavelength at 25°C of the barrier layer is 700 nm or more and less than 1000 nm and the bandgap wavelength of the first optical guide layer and the second optical guide layer is substantially equal with or less than that of the barrier layer.

BRIEF DESCRIPTION OF THE DRAWINGS

Fig 1 is a graph illustrating a relation between the bandgap wavelength of a barrier layer and a relaxation oscillation frequency in an InGaAlAs laser according to this invention;

Fig 2 is a graph illustrating a relation between the bandgap wavelength of a barrier layer and a threshold current in an InGaAlAs laser according to this invention;

Fig. 3 is a cross sectional view on a plane perpendicular to the progressing direction of light and a view illustrating a laminate structure near an active layer region in an FP ridge laser device as a first embodiment of this invention;

Fig. 4 is a cross sectional view on a plane perpendicular to the progressing direction of light and a view illustrating a band structure of a principal portion of a BH laser device as a second embodiment of this invention;

Fig. 5 is a cross sectional view on a plane perpendicular to the progressing direction of light of a BH laser device as a second embodiment of this invention;

Fig. 6 is a view comparing InGaAsAs multiple quantum well structure and an InGaAsP multiple quantum well structure; and

Fig. 7 is a perspective view illustrating an example of an optical module.

DESCRIPTION OF THE PREFERRED EMBODIMENTS

Principal embodiments of this invention are set force below in accordance with the gist of the invention.

This invention provides, as a first embodiment, a semiconductor laser device comprising, as an active layer region, a multiple quantum well structure constituted with a well layer having at least one member selected from the group consisting of InGaAs and InGaAlAs and a barrier layer having at least one member selected from the group consisting of InGaAlAs and InAlAs in which a lasing wavelength is 1.2 $\mu$m or more and a bandgap wavelength at 25°C of the barrier layer is less than 950 nm.

The bandgap wavelength is preferably 700 nm or more. The reason is as described below. Since the barrier layer consists of InGaAlAs or InAlAs, the lower limit for the bandgap wavelength is determined in itself. The bandgap wavelength of the barrier layer is shortest when InAlAs having greatest Al composition is used as the barrier layer. In InAlAs on the InP substrate, larger tensile strain is introduced as the Al composition is greater. Assuming the practical limit for the amount of tensile strain as 0.6%, the barrier layer composition at the limit is $In_{0.435}Al_{0.565}As$ and the bandgap wavelength is 700 nm. This is considered as a practical lower limit of the bandgap of the barrier layer.

Concrete compositions for InGaAs and InGaAlAs, as well as InGaAlAs and InAlAs are determined depending on the lasing wavelength required for the semiconductor laser device. This invention is useful, particularly, to semiconductor laser devices having a lasing wavelength mainly from 1.3 $\mu$m band to 1.55 $\mu$m. Accordingly, this invention is extremely useful as a light source for optical communication. This is applicable also to various semiconductor layers relevant to this invention. In general, optical communication in 1.3 $\mu$m uses a wavelength range of $1.31 \pm 0.02$ $\mu$m and optical communication in 1.55 $\mu$m uses the wavelength of about $1.55 \pm 0.02$ $\mu$m at present.

As a semiconductor substrate carrying an active layer region comprising the multiple quantum well structure can use, for example, an InP substrate or InGaAs substrate. However, InP substrate of a binary compound semiconductor material is extremely useful practically. The ternary compound semiconductor material involves a large practical difficulty such as control for the composition thereof.

As the multiple quantum well structure, various types of multiple quantum well structures used generally so far such as a strained multiple quantum well structure and starin-compensated multiple quantum well structure can be used. As the period for the quantum well, 5 period to 10 period has often been used generally although it naturally depends on the required characteristics.

This invention provides, as a second embodiment, a semiconductor laser device comprising, as an active layer region, a multiple quantum well structure constituted with a well layer having at least one member selected from the group consisting of InGaAs and InGaAlAs and a barrier layer having at least one member selected from the group consisting of InGaAlAs and InAlAs in which an lasing wavelength is 1.2 µm or more, preferably 1.6 µm or less, and a bandgap wavelength at 25°C of the barrier layer is less than 950 nm and utilizing the characteristics that the relaxation oscillation frequency increases as the bandgap wavelength of the barrier layer is shorter.

The oscillation wavelength determined as 1.2 µm or more, because a sufficient bandgap difference is necessary between the well layer and the barrier layer for developing the effect of this invention and, for this purpose, the bandgap wavelength of the well layer should not be too short. Accordingly, the lower limit of the oscillation frequency is determined necessarily and this is about 1.2 µm. The upper limit value of 1.6 µm is determined based on the upper limit wavelength used for the lasers for optical communication.

With the reason described above, the bandgap wavelength is preferably 700 nm or more.

This invention provides, as a third embodiment, a semiconductor laser device comprising, as an active layer region, a multiple quantum well structure constituted with a well layer having at least one member selected from the group consisting of InGaAs and InGaAlAs and a barrier layer having at least one member selected from the group consisting of InGaAlAs and InAlAs, having a p-side optical guide layer and an n-side optical guide layer vertically sandwiching the active layer region in the laminating direction thereof, in which a lasing wavelength is 1.2 µm or more, a bandgap wavelength at 25°C of the barrier layer is less than 1000 nm, each of the p-side optical guide layer and the n-side optical guide layer has at least one member selected from the group consisting of InGaAlAs and InAlAs, and the bandgap wavelength at 25°C is substantially equal with or shorter than the bandgap wavelength of the barrier layer.

The bandgap wavelength is preferably 700 nm or more. The reason is identical with that described previously.

The threshold current density can be decreased by making the optical guide layers on both sides in contact with the active layer region bandgap wavelength identical with or shorter than that of the barrier layer thereby increasing the carrier confining effect to the active layer.

This invention provides, as a fourth embodiment, a semiconductor laser device comprising, as an active layer region, a multiple quantum well structure constituted with a well layer having at least one member selected from the group consisting of InGaAs and InGaAlAs and a barrier layer having at least one member selected from the group consisting of InGaAlAs and InAlAs, having a p-side optical guide layer and an n-side optical guide layer vertically sandwiching the active layer region in the laminating direction thereof, in which a lasing wavelength is 1.2 µm or more, a bandgap wavelength at 25°C of the barrier layer is less than 1000 nm, utilizing the characteristics that the relaxation oscillation frequency increases as the bandgap wavelength of the barrier layer is shorter, each of the p-side guide layer and n-side guide layer has at least one member selected from the group consisting of InGaAlAs and InAlAs, and the bandgap wavelength at 25°C thereof is substantially equal with or shorter than the bandgap wavelength of the barrier layer.

With the reason described above, the bandgap wavelength is preferably 700 nm or more.

This invention provides, as a fifth embodiment, a semiconductor laser device as described in the third or fourth embodiment, wherein the n-side guide layer comprises InP or InGaAsP having such a bandgap wavelength that the valence band energy to the holes is higher relative to the barrier layer at 25°C. In most cases, the n-side guide layer comprises InP or has a bandgap wavelength of less than 1250 nm at 25°C.

As the light(optical) feedback function, those optical feedback functions used in the field of semiconductor lasers such as a Fabry - Perot interferometer or a constitution having a diffraction grating structure in a range included in an optical electric field generated in the active layer region, for example, DFB (Distributed Feedback) laser or DBR (Distributed Bragg Reflector) laser.

For confining light in the lateral direction in the active layer region, any of structures known so far such as a stripe structure of a ridge wave guide type or buried hetero type can be used. Further, in practicing this invention, those techniques used in usual semiconductor devices such as a buffer layer for improving crystal quality or a protection film for the light emission facet can of course be adopted.

Prior to explanation for concrete practice embodiments of this invention, general descriptions and operations of the semiconductor laser device according to this invention is to be explained in details.

At first, the InGaAlAs laser and the InGaAsP laser are compared and description will be made to explain that the InGaAlAs laser is a material excellent in high temperature characteristics, as well as suitable to attain high relaxation oscillation frequency.

Electrons have small effective mass and the energy distribution tends to be widened. Then, the degree of the quantum effect in the quantum well structure, that is, the energy difference between sub-bands gives a remarkable effect on the energy distribution of electrons in the well and the electron injection efficiency to the ground level. That is, the quantum effect develops more intensely as the energy barrier ΔEc in the quantum well structure is higher to increase the differential gain and also improve the response upon high speed modulation by efficient electron injection to the ground level. This effect is saturated along with increase in the energy barrier. However, for electrons of small effective mass, ΔEc at about 100 meV is insufficient in high degree such as 85°C for suppressing degradation of the high speed modulation characteristics due to the widening of the energy distribution and it is desirable that it can be increased to 300 meV or higher.

However, in the InGaAsP laser, when the valence band offset ΔEv is excessively high, not uniform injection of positive holes occurs to deteriorate the performance, so that the bandgap wavelength of the barrier layer can not be shorter than 1.05 μm. ΔEc at the limit is about 90 meV, which is insufficient for attaining a satisfactory high speed modulation characteristic.

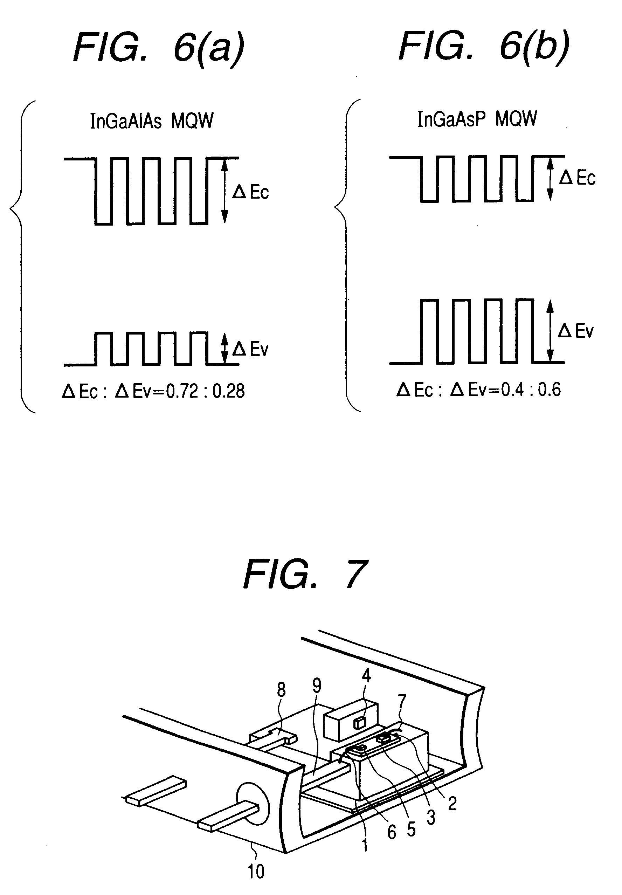

On the other hand, MQW of the InGaAlAs laser has large conduction band energy offset and small valence band energy offset. Accordingly, even when the energy barrier is increased for increasing the quantum effect to increase the relaxation oscillation frequency, lowering of the relaxation oscillation frequency caused by holes as the bottle neck less occurs as in the case of the InGaAsP laser. Fig. 6 shows the band structure of the InGaAlAs multiple quantum well structure (Fig. 6(a)) and that of the InGaAsP multiple quantum well structure (Fig. 6(b)) in comparison. Since the InGaAlAs multiple quantum well structure has lower valence band offset ΔEv compared with the InGaAsP multiple quantum well structure, it has an advantage that the hole confinement effect is not excessively large.

The relation for each of the bandgap difference ΔEg between the well layer and the barrier layer, the conduction band energy offset ΔEc and the valence band offset ΔEv in the InGaAlAs laser MQW is quantitatively shown as below.

$$\Delta Ec = 0.72\ \Delta Eg,\ \Delta Ev = 0.28\ \Delta Eg$$

On the contrary, the following relation exists in MQW of the InGaAsP laser:

$$\Delta Ec = 0.4\Delta Eg,\ \Delta Ev = 0.6\Delta Eg$$

The relations are reported, for example, in IEEE, Journal of Quantum Electronics, vol. 30, 1994, p.511.

Then, the present inventor has considered that the relaxation oscillation frequency may be improved by making the bandgap wavelength of the barrier layer shorter to a region not studied so far for InGaAlAs lasers, and has studied on the relation between the barrier layer bandgap wavelength and the laser characteristics.

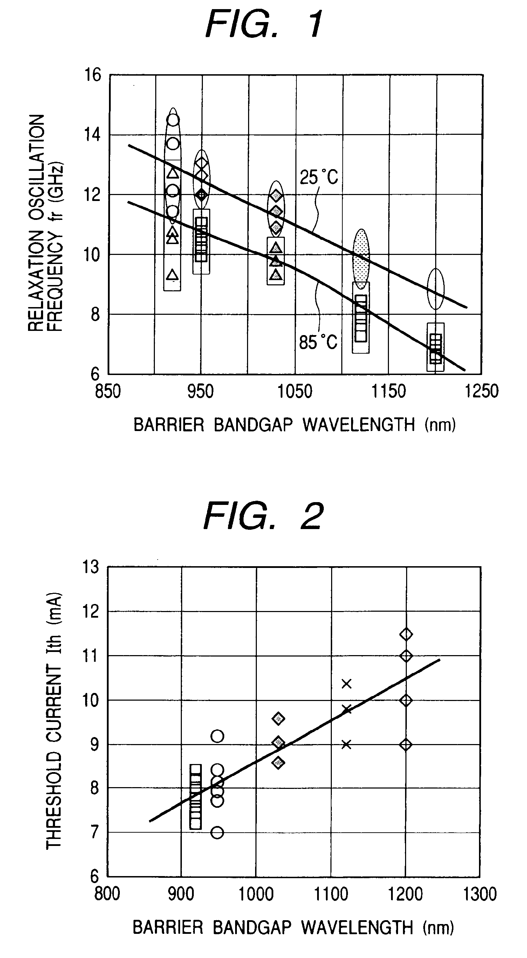

Fig. 1 shows a result for experimental study on the relaxation oscillation frequency to the barrier bandgap wavelength of the MQW active layer in a 1.3 μm InGaAlAs laser. The abscissa expresses the composition of the barrier layer as the bandgap wavelength and the ordinate expresses the relaxation oscillation frequency. The composition of the well layer is actually adapted such that the lasing wavelength is in the 1.3 μm band in accordance with in each of the barrier layers. In this example, the cavity length of the laser is 200 μm and the reflectance at the front facet and the rear facet are 70% and 90% respectively. Fig. 1 shows an example where the atmospheric temperature is at 25°C and 85°C. Indeed, experimental scatterings exist as shown in the figure but, different from the case of the InGaAsP laser, no saturation tendency is found in the effect of increasing the relaxation oscillation frequency due to the shortening of the barrier layer wavelength and increase in the relaxation oscillation frequency is found also in the region of the bandgap wavelength of less than 1.0 μm. The experimental result shown in Fig. 1 means that even when the bandgap wavelength of the barrier layer is shortened, there is an effect that the oscillation wavelength frequency is increased beyond the decreasing the degree of the optical confinement factor by the lowering of the effective refractive index of the active layer.

This is an effect that the energy barrier ΔEc and ΔEv of the quantum well increase along with the shortening of the barrier layer wavelength to increase the differential gain.

The relaxation frequency oscillation fr in the semiconductor laser is given by the following equation (1) :

$$f_r = \frac{1}{2\pi}\sqrt{\frac{\Gamma\left(\dfrac{dg}{dn}\right)S}{\tau_p}} \qquad\qquad ----- \text{(Equation 1)}$$

where r represents an optical confinement factor, dg/dn represents a differential gain, S represents a photon density and τp represents a photon lifetime. According to the equation (1), the relaxation oscillation frequency increases and the high speed modulation performance of the laser is improved by increasing the optical confinement factor and the differential gain.

In the InGaAsP laser, fr lowers since ΔEv is excessively high. However, in the 1.3 μm band InGaAlAs laser,

$\Delta Ec$ is 320 meV and $\Delta Ev$ is 135 meV in the laser of the barrier layer bandgap wavelength of 900 nm for instance, which is within a range of $\Delta Ev$ not causing lowering of the relaxation oscillation frequency. In addition, in this case, since $\Delta Ec$ at 300 meV or higher can be attained, large increase of fr due to the effect of the increase in the differential gain can be obtained.

The effect of this invention and the difference with conventional InGaAsP laser are to be explained supplementally.

The following examples have been reported for the relation between the relaxation oscillation frequency and the barrier layer composition of the InGaAsP laser.

(1) Japanese Patent Laid-Open Hei 7-221395
(2) Japanese Patent Laid-Open Hei 6-342959

In the publication (1) above, it is described that the efficiency is lowered due to not uniform injection of holes when the energy difference between the ground level of the hole and the valence band top of the barrier layer in the well layer is 160 meV or higher. This energy difference is substantially equal with $\Delta Ev$. Further, in the publication (2) it is described that the relaxation oscillation frequency reaches maximum at the barrier layer bandgap wavelength of 1.05 μm and the relaxation oscillation frequency lowers remarkably when the wavelength is shortened to 1.00 μm in the 1.3 μm InGaAsP laser. When $\Delta Ev$ at the barrier layer bandgap wavelength of 1.05 μm is calculated, it is also about 160 meV. As described above, lowering of the relaxation oscillation frequency due to not uniform injection of holes does not occur within a range of $\Delta Ev$ of 160 meV or smaller. It appears that the relation may be applicable also to the InGaAlAs laser but, since $\Delta Ev$ is small in the InGaAlAs laser, $\Delta Ev$ is within an applicable range of 160 meV or lower even when the barrier layer bandgap wavelength is less than 950 nm.

Further, the effect of decreasing the current density also contributes to the increase of fr. Fig. 2 shows measured values for the threshold current at 25°C in the laser the result of experiment of which is shown in Fig. 1. The abscissa expresses the bandgap wavelength corresponding to the composition of the barrier layer and the ordinate expresses the threshold current. It can be seen that the threshold current decreases as the barrier layer bandgap wavelength is shortened. This is considered to be attributable to that the carrier confinement effect is increased due to the increase of the quantum effect and, further, the ratio of the carriers in the ground level is increased, which enables the lasing at small current density. As the threshold current density decreases, the carrier density in the active layer required for lasing, that is, the threshold carrier density nth decreases. Then, since the differential gain dg/dn upon lasing is in inverse proportion with the carrier density nth, the differential gain increases as a result and the relaxation oscillation frequency fr also increases. Particularly, at high temperature, since the effect of decreasing the threshold current density by shortening of the barrier layer wavelength is increased, it can provide an effective means for realizing high fr at high temperature. More desirably, for decreasing the threshold current density, the bandgap wavelength of the guide layer on both sides in contact with the active layer may be identical with or shorter than that of the barrier layer wavelength thereby increasing the carrier confinement effect to the active layer.

When the p-side guide layer comprising a single index or a graded index of InGaAlAs or InAlAs and of the bandgap wavelength described above, electrons can be confined intensely in the active layer. The n-side guide layer may also be formed of identical material and bandgap wavelength. InP has an intense effect of confining holes into the active layer and, further, InGaAsP having an appropriate bandgap wavelength is also effective. That is, so long as the valance band energy of the n-side guide layer constitutes a barrier relative to the valance band energy of the barrier layer of the MQW active layer, it has an effect of confining holes into the active layer and it may suffice that such an n-side guide layer is provided. InP has a high valence band energy for InAlAs or InGaAlAs of any composition having a lattice constant at a level that can be prepared on an InP substrate. Further, with reference to InGaAsP, the InGaAsP bandgap wavelength constituting the valence bandgap energy barrier to the barrier layer InGaAlAs can be calculated by applying relation: $\Delta Ec = 0.72\Delta Eg$, $\Delta Ev = 0.28\Delta Eg$ to the InGaAs-InGaAlAs - InAlAs series materials and applying a relation: $\Delta Ec = 0.4\Delta Eg$, $\Delta Ev = 0.6\Delta Eg$ to the InGaAs - InGaAsP series materials.

For example, with respect to InGaAlAs having a bandgap wavelength of 1000 nm, 950 nm and 900 nm, InGaAsP of the bandgap wavelength, respectively, of 1250 nm, 1210 nm and 1170 nm or less has higher valence band energy. As described above an InGaAsP layer of an appropriate bandgap wavelength may be selected in accordance with the composition of the barrier layer InGaAlAs and used as the n-side guide layer.

As has been described above, the semiconductor laser having the MQW structure comprising InGaAlAs has a characteristic that the relaxation oscillation frequency increases monotonously as the bandgap wavelength is shortened also in a region where the barrier layer bandgap wavelength is less than 1000 nm.

Utilizing the characteristic described above, it is possible to provide a light source for optical communication having excellent high temperature characteristic and high speed modulation characteristic by an InGaAlAs laser having an MQW active layer with the barrier layer bandgap wavelength of less than 1000 nm and, preferably, less than 950 nm. Alternatively, it is possible to provide a light source for optical communication having excellent high temperature characteristic and high speed modulation characteristic by an InGaAlAs laser in which the barrier layer bandgap wavelength is less than 1000 nm and the bandgap wavelength of a guide layer of an appropriate material in contact with the active layer is equal with or shorter than the bandgap wavelength of the barrier layer.

Further, in a case of constituting an optical module by carrying a semiconductor laser device according to this invention, it is possible to provide a high speed semiconductor optical module for optical communication even without using a thermoelectric cooler for conducting so-called cooling of a light component. This is because the semiconductor laser device according to this invention can conduct a high speed operation stably without cooling at or above a temperature of an atmosphere in which the existent semiconductor laser devices operate stably. For example, a high speed operation at about 10 Gbit/s can be maintained.

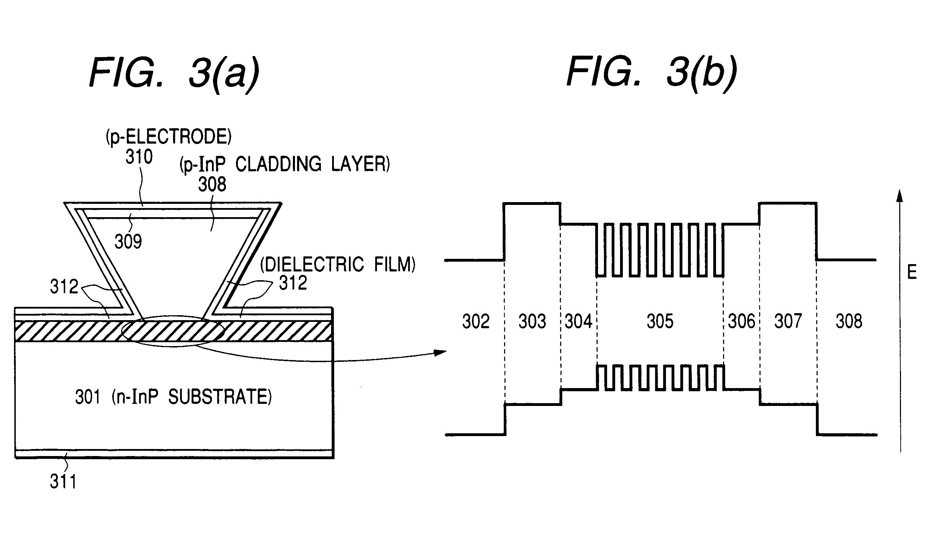

Then, a concrete embodiment of this invention is to be explained. Fig. 3 is a cross sectional view illustrating a first embodiment according to this invention: A cross sectional view on a plane crossing the progressing direction of light is shown to the left of Fig. 3, while a band structural view illustrating the layer structure near the active layer thereof is shown to the right of Fig. 3.

This example shows a multiple quantum well ridge waveguide semiconductor laser device using InGaAlAs on an InP substrate. The resonator is of a Fabry-Perot (FP) type. The lasing wavelength is 1.3 $\mu$m band.

The laser structure is prepared by crystal growth on an n-type InP substrate 301. A p-side guide layer 306 comprising $In_{0.53}Ga_{0.09}Al_{0.38}As$ and an n-side guide layer 304 comprising $In_{0.53}Ga_{0.09}Al_{0.38}As$ are formed in adjacent with an InGaAlAs multiple quantum well active layer 305, which are further sandwiched between a p-side cladding layer 307 comprising $In_{0.52}Al_{0.48}As$ and an n-side cladding layer 303 comprising $In_{0.52}Al_{0.48}As$. The thickness for each of the guide layer 306 and the guide layer 304 is 70 nm and the thickness for each of the cladding layer 307 and the cladding layer 303 is 50 nm. Each thickness is designed to an appropriate value in accordance with the thickness of the active layer 305 and the design for the field pattern of a laser beam. An n-InP layer 302 is a buffer layer for growing satisfactory crystals and also serves as an n-side cladding layer.

The p-InP cladding layer 308 is fabricated into a ridged type by etching and serves as a waveguide for the laser beam. The p-side contact layer 309 is in adjacent with a p-side electrode 310 and reduces the contact resistance with the electrode by ohmic contact. The surface excepting the upper surface of the ridge is protected with a dielectric film 312. Further, an n-side electrode 311 is formed at the back of the substrate.

The active layer 305 has a multiple quantum well structure comprising an $In_{0.53}Ga_{0.09}Al_{0.38}As$ barrier layer (10 nm thickness) and an $In_{0.70}Ga_{0.14}Al_{0.16}As$ well layer (5 nm thickness) in which the number of well layers is 8. For conducting high speed modulation, the number of well layers is selected appropriately within a range from 4 to 15.

Each of the p-InP waveguide layer 308, the p-side cladding layer of $In_{0.53}Al_{0.48}As$, and the p-side guide layer 306 comprising $p-In_{0.52}Ga_{0.10}Al_{0.37}As$ is doped at a concentration of $1 \times 10^{18}$ cm$^3$. Further, each of the n-side cladding layer 303 comprising $In_{0.52}Al_{0.48}As$ and the n-side guide layer 304 comprising $n-In_{0.53}Ga_{0.10}Al_{0.37}As$ is doped at a concentration of $1 \times 10^{18}$ cm$^3$. Such doping concentration is an example and any appropriate value may be selected in accordance with the design. The p-side guide layer 306 may be sometimes undoped or doped at low concentration considering the diffusion of the p-type dopant.

What is important is the selection for the composition of the p- and n-side guide layers 306 and 304, as well as the barrier layer. In this example, the bandgap wavelength of the barrier layer is 940 nm, and the p- and n-side guide layers 306 and 304 are made to identical composition. In this way, high relaxation oscillation frequency is obtainable to enable high speed modulation excellent over existent semiconductor lasers. This can be used as a light source for optical module of 10 Gbit/s direct modulation without using a thermoelectric cooler. Not only the example illustrated here but also other active layers and optical guide regions having the quantum well structure conforming the gist of this invention can provide the same effect.

In addition, the structure of the layer in contact with the active layer 305 on the n-side may, for example, be a structure in which the n-side guide layer 304 comprising $In_{0.53}Ga_{0.09}Al_{0.38}As$ is not present but the $n-In_{0.52}Al_{0.48}As$ layer 303 is in direct contact with the active layer 305, and the same effect can also be obtained, for example, in a case where the layer 303 is InP or InGaAsP with the bandgap wavelength of 1200 nm or less.

The composition for the well layer is $In_{0.70}Ga_{0.14}Al_{0.16}As$ and put under 1.2% compressive strain. The amount of compressive strain may be changed appropriately and it may be a tensile strain. Further, it can be formed as a nustrained well layer lattice matching with InP.

The structure for confining light and current in the lateral direction of this embodiment is of a ridged type but what is important is a layer structure of the active layer and guide layers for putting the same therebetween. Accordingly, same effects can also be obtained by applying not only the ridge type but also the semiconductor laser of any other stripe structures such as buried hetero-type (BH) or the like.

Further, in this invention, various kinds of usual light feedback methods can be used. Accordingly, when this invention is applied not only to the FP laser illustrated in this embodiment but to a distributed feedback type (DFB) laser or a distributed Bragg reflector (DBR) laser, an light source for transmission for a longer distance can be obtained.

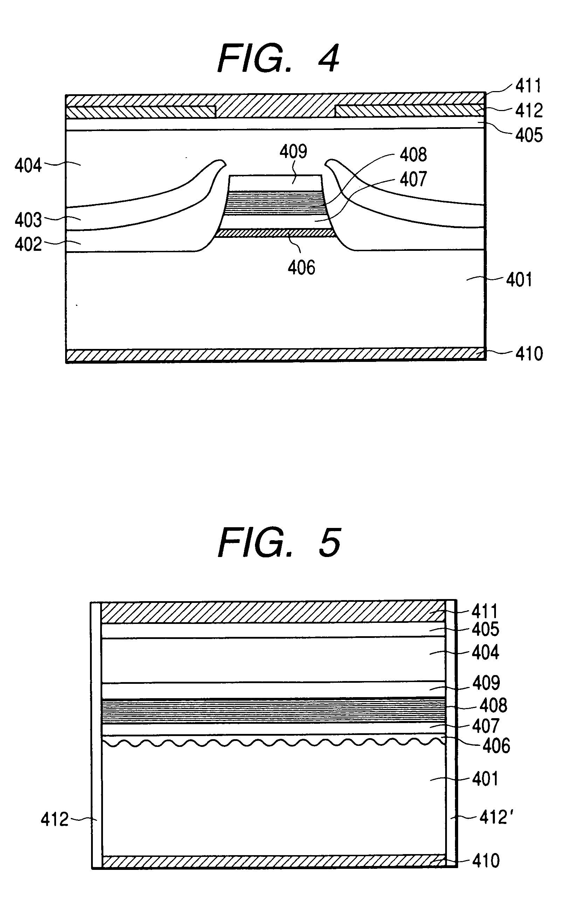

Fig. 4 is a cross sectional view on a plane crossing the progressing direction of a light in a device showing a second embodiment according to this invention. The second embodiment shows a DFB laser of a BH structure prepared on an InP substrate. Fig. 5 is a cross sectional view on a plane in parallel with the progressing direction of light in the active layer and the layer in the vicinity thereof.

On an n-InP substrate 401 having a grating pattern on the surface, are formed an n-InGaAsP (bandgap wavelength: 1.2 μm) diffraction grating layer 406, an n-In$_{0.52}$Al$_{0.48}$As guide layer 407, an InGaAlAs multiple quantum well active layer 408 and a p-In$_{0.52}$Al$_{0.48}$As guide layer. The InGaAlAs multiple quantum well active layer 408 has a structure in which an In$_{0.48}$Ga$_{0.12}$Al$_{0.39}$As barrier and an In$_{0.62}$Ga$_{0.22}$Al$_{0.16}$As well layer are laminated having the number of wells is 5. The thickness for the barrier layer and the well is 8 nm and 6 nm respectively and the thickness for the p- and n-side guide layers 409 and 407 is 100 nm respectively. The layers are etched in a stripe pattern with several μm width and then both sides of the stripe-like regions are buried by a p-InP block layer 402, an n-InP block layer 403 and a p-InP cladding layer 404. The p-side surface is covered with a dielectric protection layer 412 and is in contact with a p-side electrode 411 by way of the p-In$_{0.53}$Ga$_{0.47}$As contact layer 405 only just above the active layer 408. Further, an n-side electrode 410 is vapor deposited on the rear facet of the substrate 401. Protection films 412, 412' are disposed to the light emitting facet of the semiconductor laser device. The protection films 412, 412' are usually insulative and sometimes constituted with a plurality of layers. It may suffice that the protection film itself is a usual film. The lasing wavelength of the laser is about 1.3 μm at a room temperature.

The p- and n-side guide layers 409 and 407 are lattice matched to the InP substrate and the bandgap wavelength is 850 nm. The barrier layer is at the bandgap wavelength of 900 nm and put under 0.3% tensile strain. The well layer is applied with 0.6% compressive strain to provide a so-called strain compensated multiple quantum well structure.

In this embodiment, strain is applied to the barrier wall and it is also possible in this case to attain a semiconductor laser of excellent high speed operation characteristic even at a high temperature by making the bandgap wavelength to less than 950 nm. Furthermore, by making the bandgap wavelength of the guide layer sandwiching the active layer 408 therebetween to 850 nm which is shorter than that of the barrier layer, the effect can be made more reliable. The doping concentration to the guide layer may be set to an appropriate concentration like that in the first embodiment.

Further, as has been described for the first embodiment, the layer structure of this embodiment is applicable to semiconductor lasers of any of stripe structures such as a ridge type laser. Further, the structure for the grating is not restricted only to the example illustrated here but the structure may be such that the diffraction grating layer 406 comprises InGaAs or InGaAlAs, and the situation is quite identical in a case where the diffraction grating layer is disposed on the p-side of the active layer 408. As described above, the similar effect is obtained by adopting the layer structure of this invention irrespective the waveguide structure and the resonator structure.

Fig. 7 is a perspectaive view illustrating an example of an optical module according to this invention. A semiconductor laser device 2 according to this invention is contained in a case 10 of an optical module. The semiconductor laser device 2 is mounted on a sub-mount 3, and the sub-mount 3 is disposed on a substrate 1 for carrying a predetermined laser. In this example, one electrode of the semiconductor laser device 2 is connected from a pad 5 by way of a wire 6 to a lead 9, while the other electrode is connected by way of a wire 7 to a laser carrying substrate 1. The lead 9 is led externally of the case 10. On the other hand, the laser carrying substrate 1 is connected with a lead 8 and led externally out of the case 10. As seen in this example, optical modulation for optical communication is possible at high temperature without using a thermoelectric cooler, for example, a Peltier device usually disposed to the laser device, by the use of the semiconductor laser device according to this invention. Thus, this invention can provide a uncooled light source, by which modulation of 10 Gbit/s or more is enabled, for example, by a direct modulation system.

As has been described above referring to various embodiments, a semiconductor laser capable of realizing favorable temperature characteristic and high super-high speed modulation can be provided.

The MQW semiconductor laser comprising the InGaAlAs material according to this invention can make the barrier height of the conduction band and the valence band sufficiently higher without not uniform injection of holes to the well layer and can obtain a large differential gain over a wide temperature range. Further, according to this invention, the threshold current density can be decreased and the threshold carrier density is reduced. The relaxation oscillation frequency is increased by such effects. That is, the present inventors have found the phenomenon that the relaxation oscillation frequency is further increased by using the barrier layer having the bandgap wavelength of less than 950 nm to 1000 nm in which the relaxation oscillation frequency has been reduced in the existent lasers. It has been possible to provide a semiconductor laser suitable to conduct high speed modulation in a wide range of temperature by utilizing the characteristic.

According to the embodiments of this invention, a compound semiconductor laser device capable of ensuring high speed operation even in a high temperature atmosphere can be provided. Furthermore, this invention is useful, particularly, to a compound semiconductor laser device having a lasing wavelength at 1.3 μm to 1.55 μm.

**Claims**

1. A semiconductor laser device having, as an active layer, a multiple quantum well structure comprising a well layer having at least one member selected from the group consisting of InGaAs and InGaAlAs and a barrier layer having at least one member selected from the group consisting of InGaAlAs and InAlAs, in which a lasing wavelength is 1.2 μm or more and a bandgap wavelength at 25°C of the barrier layer is less than 950 nm.

2. A semiconductor laser device as defined in claim 1, wherein the characteristic that the relaxation oscillation frequency increases as the bandgap wavelength of the barrier layer is shortened.

3. A semiconductor laser device as defined in claim 1, wherein the light feedback function is provided by a Fabry-Perot resonator.

4. A semiconductor laser device as defined in claim 1, wherein the light feedback function is provided by the provision of a grating structure in a range included in an optical electric field generated in the active layer region.

5. A semiconductor laser device as defined in claim 1, having a stripe structure of a ridge waveguide type or a buried hetero type.

6. An optical module carrying a semiconductor laser device as defined in claim 1 without providing a thermoelectric cooler.

7. A semiconductor laser device having, as an active layer, a multiple quantum well structure comprising a well layer having at least one member selected from the group consisting of InGaAs and InGaAlAs and a barrier layer having at least one member selected from the group consisting of InGaAlAs and InAlAs and having a p-side optical guide layer and an n-side optical guide layer vertically sandwiching the active layer in the laminating direction thereof, in which the lasing wavelength is 1.2 μm or more, the bandgap wavelength at 25°C of the barrier layer is less than 1000 nm, each of the p-side guide layer and the n-side guide layer has at least one member selected from the group consisting of InGaAlAs and InAlAs, and the bandgap wavelength at 25°C thereof is substantially identical with or shorter than the bandgap wavelength of the barrier layer.

8. A semiconductor laser device as defined in claim 7, wherein the n-side guide layer comprises InP or InGaAsP having such a bandgap wavelength that a valence band energy to holes is higher relative to the barrier layer at 25°C.

9. A semiconductor laser device as defined in claim 7, wherein the light feedback function is provided by a Fabry-Perot resonator.

10. A semiconductor laser device as defined in claim 7, wherein the light feedback function is provided by a grating structure in a range included by an optical electric field generated in the active layer region.

11. A semiconductor laser device as defined in claim 7, having a stripe structure of a ridge waveguide type or a buried hetero type.

12. An optical module carrying a semiconductor laser device as defined in claim 7 without providing a thermoelectric cooler.

13. A semiconductor laser device having, as an active layer, a multiple quantum well structure comprising a well layer having at least one member selected from the group consisting of InGaAs and InGaAlAs and a barrier layer having at least one member selected from the group consisting of InGaAlAs and InAlAs, having a p-side optical guide layer and an n-side optical guide layer vertically sandwiching the active layer in the laminating direction thereof, in which the oscillation wavelength is 1.2 μm or more, the bandgap wavelength at 25°C of the barrier layer is less than 1000 nm, utilizing the characteristic that the relaxation oscillation frequency increases as the bandgap wavelength of the barrier layer is shortened, each of the p-side guide layer and the n-side guide layer has at least one member selected from the group consisting of InGaAlAs and InAlAs and the bandgap wavelength at 25°C thereof is substantially identical or shorter than the bandgap wavelength of the barrier layer.

14. A semiconductor laser device as defined in claim 13, wherein the n-side guide layer comprises InP or InGaAsP having such a bandgap wavelength that a valence band energy to holes is higher relative to the barrier layer at 25°C.

**15.** A semiconductor laser device as defined in claim 13, wherein the light feedback function is provided by a Fabry-Perot resonator.

**16.** A semiconductor laser device as defined in claim 13, wherein the light feedback function is provided by a grating structure in a range included by an optical electric field generated in the active layer region.

**17.** A semiconductor laser device as defined in claim 13, having a stripe structure of a ridge waveguide type or a buried hetero type.

**18.** An optical module carrying a semiconductor laser device as defined in claim 13 without providing a thermoelectric cooler.

## FIG. 1

## FIG. 2

# FIG. 3(a)

(p-ELECTRODE)
310

(p-InP CLADDING LAYER)
308

309

312

(DIELECTRIC FILM)
312

312

301 (n-InP SUBSTRATE)

311

# FIG. 3(b)

| 302 | 303 | 304 | 305 | 306 | 307 | 308 |

E

EP 1 202 410 A2

# FIG. 4

# FIG. 5

# FIG. 6(a)

InGaAlAs MQW

$\Delta Ec$

$\Delta Ev$

$\Delta Ec : \Delta Ev = 0.72 : 0.28$

# FIG. 6(b)

InGaAsP MQW

$\Delta Ec$

$\Delta Ev$

$\Delta Ec : \Delta Ev = 0.4 : 0.6$

# FIG. 7